# EUROPÄISCHE PATENTSCHRIFT

(11) **EP 2 534 711 B1**
(45) Veröffentlichungstag und Bekanntmachung des Hinweises auf die Patenterteilung: **02.09.2015**
(21) Anmeldenummer: 11703662.4
(22) Anmeldetag: 10.02.2011
(51) Int. Cl.: H01L 51/50, H01L 51/30, H01L 51/42, C09K 11/06

(54) **VERWENDUNG VON GOLD-KOMPLEXEN IN OPTO-ELEKTRONISCHEN VORRICHTUNGEN**
USE OF GOLD-COMPLEXES IN OPTO-ELECTRONIC DEVICES
UTILISATION DE COMPLEXES D'OR DANS LES DISPOSITIFS OPTOÉLECTRONIQUES

(30) Priorität: 11.02.2010 DE 102010007825
(43) Veröffentlichungstag der Anmeldung: 19.12.2012
(73) Patentinhaber: cynora GmbH, 76646 Bruchsal (DE)
(72) Erfinder: CZERWIENIEC, Rafal, 93083 Obertraubling (DE); YERSIN, Hartmut, 93161 Sinzing (DE); MONKOWIUS, Uwe, A-4020 Linz (AT); HOFBECK, Thomas, 92342 Freystadt (DE); LAGUNA, Antonio, E-50010 Zaragoza (ES); CRESPO, Olga, E-50010 Zaragoza (ES); CONCEPCION GIMENO, Maria, E-50003 Zaragoza (ES)
(74) Vertreter: Hoppe, Georg Johannes
(86) Internationale Anmeldenummer: PCT/EP2011/051965
(87) Internationale Veröffentlichungsnummer: WO 2011/098522

(56) Entgegenhaltungen:
- EP-A1- 2 088 151
- DE-A1-102008 033 563
- CRESPO O ET AL: "Luminescent nido-Carborane-Diphosphine Anions", INORGANIC CHEMISTRY, AMERICAN CHEMICAL SOCIETY, EASTON, US, Bd. 42, Nr. 6, 1. Januar 2003 (2003-01-01) , Seiten 2061-2068, XP002501593, ISSN: 0020-1669, DOI: DOI:10.1021/IC0259843
- PANKAJ SINHA, ANGELA, K. WILSON, MOHAMMAD A. OMARY: "Beyond a T-Shape", JOURNAL OF THE AMERICAN CHEMICAL SOCIETY, Bd. 127, 18. August 2005 (2005-08-18), Seiten 12488-12489, XP002631855,

## Beschreibung

Die vorliegende Erfindung betrifft die Verwendung von Gold(I)-Komplexen mit planar-trigonaler Koordinationsgeometrie und mehrbindigen Liganden in opto-elektronischen Vorrichtungen.

### Einleitung

Zur Zeit zeichnet sich ein besonders drastischer Wandel im Bereich der Bildschirm- und Beleuchtungstechnik ab. Es wird möglich sein, flache Displays oder Leuchtflächen mit einer Dicke von unter 0,5 mm zu fertigen. Diese sind durch viele faszinierende Eigenschaften gekennzeichnet. So werden z. B. Leuchtflächen als Tapeten mit sehr geringem Energieverbrauch realisierbar sein. Besonders interessant ist auch, dass Farbbildschirme mit bisher nicht erreichbarer Farb-Echtheit, Helligkeit und Blickwinkelunabhängigkeit, mit geringem Gewicht sowie sehr niedrigem Stromverbrauch herstellbar sein werden. Die Bildschirme werden sich als Mikro-Displays oder Großbildschirme mit mehreren Quadratmetern Fläche in starrer Form oder flexibel, aber auch als Transmissions- oder Reflexions-Displays gestalten lassen. Ferner wird es möglich sein, einfache und kostensparende Herstellungsverfahren wie Siebdruck oder Tintenstrahldruck oder Vakuum-Sublimation einzusetzen. Dadurch wird im Vergleich zu herkömmlichen Flachbildschirmen eine preiswerte Fertigung ermöglicht. Diese neue Technik basiert auf dem Prinzip der OLEDs, den Organic Light Emitting Diodes.

OLEDs bestehen vorwiegend aus organischen Schichten, die auch flexibel und kostengünstig zu fertigen sind. OLED-Bauelemente lassen sich großflächig als Beleuchtungskörper, aber auch klein als Pixels für Displays gestalten.

Gegenüber herkömmlichen Technologien, wie etwa Flüssigkristall-Displays (LCDs), Plasma-Displays oder Kathodenstrahlenröhren (CRTs) weisen OLEDs zahlreiche Vorteile auf, wie eine geringe Betriebsspannung, eine dünne Struktur, hoch-effizient selbstleuchtende Pixel, einen hohen Kontrast und eine gute Auflösung sowie die Möglichkeit, alle Farben darzustellen. Weiterhin emittiert ein OLED Licht beim Anliegen elektrischer Spannung anstelle es nur zu modulieren.

Einen Überblick über die Funktion von OLEDs findet sich beispielsweise bei H. Yersin, Top. Curr. Chem. 2004, 241,1 und H. Yersin, "Highly Efficient OLEDs with Phosphorescent Materials", Wiley-VCH, Weinheim, Germany, 2008.

Seit den ersten Berichten über OLEDs (s. z. B. Tang et al., Appl. Phys. Lett. 51 (1987) 913) sind diese Vorrichtungen insbesondere im Hinblick auf die eingesetzten Emittermaterialien weiterentwickelt worden, wobei insbesondere sogenannte Triplett- oder auch andere phosphoreszierende Emitter von Interesse sind.

Entscheidend für den Bau hoch- effizienter OLEDs sind die verwendeten Leuchtmaterialien (Emitter-Moleküle). Diese können in verschiedener Weise realisiert werden, und zwar unter Verwendung rein organischer Moleküle oder metallorganischer Komplexverbindungen. Es lässt sich zeigen, dass die Lichtausbeute der OLEDs mit metallorganischen Substanzen, den sog. Triplett-Emittern, wesentlich größer sein kann als für rein organische Materialien. Aufgrund dieser Eigenschaft kommt der Weiterentwicklung der metallorganischen Materialien ein wesentlicher Stellenwert zu.

Unter Einsatz von metallorganischen Komplexen mit hoher Emissionsquantenausbeute (aus den untersten Triplett-Zuständen zu den Singulett-Grundzuständen) lässt sich eine besonders hohe Effizienz des OLEDs erzielen. Diese Materialien werden häufig als Triplett-Emitter oder phosphoreszierende Emitter bezeichnet.

Es ist bekannt, dass Gold(I)-Komplexe mit planar-trigonaler Koordinationsgeometrie und monodentaten (einbindigen) Liganden Photolumineszenz zeigen. Derartige Komplexe erleiden jedoch beim elektronischen Übergang vom Grundzustand in den für die Emission verantwortlichen angeregten Zustand Geometrieveränderungen, was sich - wie unten weiter erläutert wird - sehr ungünstig auf die Emittersubstanz auswirkt. Infolgedessen verfügen diese Komplexe nicht über eine genügend hohe Emissionsquantenausbeute. Auch die photochemische Stabilität ist durch die starken Geometrieverändecungen vermindert. Infolgedessen sind die bekannten Komplexe für den Einsatz in optoelektronischenBauelementen, d. h. insbesondere in OLEDs, kaum geeignet.

Während dem OLED bereits zahlreiche Anwendungen erschlossen sind und auch neue Anwendungsgebiete eröffnet wurden, besteht immer noch ein Bedarf an verbesserten OLEDs und insbesondere an verbesserten Triplett-Emittermaterialien. Bei den bisherigen Lösungen sind oftmals hohe Effizienzen bei hohen Stromdichten oder hohe Leuchtdichten nicht erreichbar.

O. Crespo, Inorg. Chem., 2003, 42, 2061-2068, zeigt Gold-Komplexe mit planar-trigonaler Koordinationsgeometrie.

DE 10 2008 033 563 A1 offenbart die Verwendung von Gold-Komplexen in opto-elektronischen Vorrichtungen.

Eine Aufgabe der vorliegenden Erfindung war es, neue Emittermaterialien, insbesondere für OLEDs sowie neue Licht emittierende Vorrichtungen und andere opto-elektronische Anwendungen bereitzustellen, welche die Nachteile des Standes der Technik zumindest teilweise überwinden.

### Beschreibung

Diese Aufgabe wird durch die vorliegende Erfindung gelöst.

Detaillierte Untersuchungen haben überraschend ergeben, dass bestimmte, hier beschriebene Gold(I)-Komplexe für den Einsatz als Triplett-Emitter in OLEDs, LEECs und in anderen opto-elektronischen Vorrichtungen besonders geeignet sind.

Erfindungsgemäß werden Verbindungen gemäß Formel I als Triplett-Emitter in opto-elektronischen Vorrichtungen verwendet:

**[(L-L)(L')Au]^{0/1+} [Anion]_{0/1}** Formel (I)

Darin sind:
**(L-L)** und **(L')** Liganden,
Au ein Au⁺ Zentralion und
   **Anion** ein Anion, das vorhanden ist, wenn (L-L) und (L') neutral sind, weil dann der Komplex positiv geladen ist, d.h. [(L-L)(L')Au]¹⁺.

Je nach Wahl der Liganden (L-L) und (L') bildet sich ein geladener Komplex (Ladung +1, ein Anion) oder ein neutraler Komplex (Ladung 0, kein Anion).

Bei L-L handelt es sich um einen zweizähnigen Liganden, während L' ein einzähniger oder zweizähniger (verbrückender) Ligand ist.

Die Verbindungen werden hier auch als "Gold-Komplexe" bezeichnet. Dieser Begriff kann neben dem eigentlichen Komplex auch das ggf. vorhandene Anion umfassen und kann sich somit auf ein Komplexsalz beziehen.

Formel (I) umfasst folgende Gruppen und Untergruppen von trigonalen Verbindungen, die im Rahmen bevorzugter Ausführungsformen der Erfindung als Emitter oder Absorber in opto-elektronischen Vorrichtungen verwendet werden können:
**Gruppe A: geladene Komplexe der Formel (II)**

   **[(L-L)(L')Au]¹⁺ [Anion]** Formel **(II)**

   - **Untergruppe A1:** (L-L) ist ein neutraler, bidentater (zweizähniger) Ligand, L' ist ebenfalls ein neutraler bidentater Ligand: Aufgrund der Zweizähnigkeit von L' ergibt sich die empirische Formel **[(L-L)(L')_{0,5}Au]¹⁺ [Anion].**
   - **Untergruppe A2:** (L-L) ist ein neutraler, bidentater Ligand, L' ist ein neutraler, monodentater Ligand: Es ergibt sich die empirische Formel **[(L-L)(L')Au]¹⁺ [Anion].**
   - **Untergruppe A3:** L' ist zusätzlich mit (L-L) verbunden und bildet einen neutralen, tridentaten Liganden (L-L-L'): Es ergibt sich die empirische Formel **[(L-L-L')Au]¹⁺** [**Anion**].
**Gruppe B: neutrale Komplexe der Formel (III)**

   **[(L-L)(L')Au]** Formel (III)

   - **Untergruppe B1:** (L-L) ist ein neutraler, bidentater Ligand, L' ist ein einfach negativ geladener, monodentater Ligand: Es ergibt sich die empirische Formel **[(L-L)(L')Au].**
   - **Untergruppe B2:** (L-L) ist ein einfach negativ geladener, bidentater Ligand, L' ist einen neutraler, monodentater Ligand: Es ergibt sich die empirische Formel **[(L-L)(L')Au].**
   - **Untergruppe B3:** L' ist zusätzlich mit (L-L) verbunden und bildet einen einfach negativ geladenen, tridentaten Liganden (L-L-L'): Es ergibt sich die empirische Formel **[(L-L-L')Au].**

Bevorzugt ist das Vorhandensein mehrzähniger Liganden, die zu einer Versteifung der Goldkomplexe führen. Das gilt für überbrückende, aber besonders für chelatisierende Bindungsmuster, die ebenfalls bevorzugt sind. Durch die erhöhte Rigidität des Systems wird eine geometrische Verzerrung beim Übergang vom Grund- in den angeregten Zustand verringert (Übergang von der trigonalen-planaren in Richtung zu einer T-förmigen Koordination). Hierdurch steigen die Emissionsquantenausbeuten erheblich, weil thermische Relaxationsprozesse erschwert werden. Außerdem wird die Stokes-Verschiebung erheblich verringert. Dies führt in einer opto-elektronischen Vorrichtung zu einer erhöhten Energieeffizienz, was für opto-elektronische Anwendungen sehr vorteilhaft ist.

Zusätzlich steigt bei mehrzähnigen Liganden die Stabilität der Komplexe, was zu einer verlängerten Lebensdauer der jeweiligen opto-elektronischen Vorrichtung führt.

Bei den Liganden kann die Emissionswellenlänge neben der Art der Liganden L-L und L' auch durch deren sterischen Anspruch gesteuert werden. Allgemein gilt, dass Liganden mit hohem sterischen Anspruch aufgrund der dadurch eingeschränkten Möglichkeit zu einer Verzerrung im angeregten Zustand und damit einer kleineren Stokes-Verschiebung eine höhere Emissionsenergie aufweisen als Komplexe mit kleineren Liganden. Bei überbrückenden Bindungsmustern kann sich ein Koordinationspolymer oder Ringe bilden. Überbrückende Bindungsmuster sind Koordinationsgeometrien, bei denen ein mehrzähniger Ligand nicht chelatisierend wirkt, sondern zwei oder mehrere Metall-Atome miteinander verbindet. Auch hier ist die Rigidität und die Stabilität im Vergleich zu Komplexen mit ausschließlich monodentaten Liganden erhöht. Bei monomeren Komplexen können durch entsprechende Funktionalisierungen an den Liganden die Komplexe auch an Polymere gebunden werden. Abgebildet sind exemplarisch drei funktionalisierte Phosphanliganden, die leicht in Polymeren eingebaut werden können:

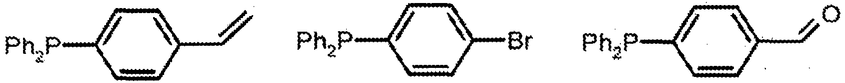

Das Vinyl-substituierte Phosphan kann leicht durch gängige Polymerisationsverfahren (anionisch, kationisch, radikalisch, katalytisch) mit weiteren Monomeren (z. B. Styrol) copolymerisiert werden oder als Seitengruppe in ein bestehendes Polymer eingebaut werden. Die Brom- und Aldehyd-substituierten Phosphane können durch Kupplungsreaktionen (z. B. Suzuki, Wittig) als Seitengruppen an ein entsprechend funktionalisiertes Polymer gebunden werden.

Ein weiterer wichtiger Vorteil von Komplexen mit hohem sterischen Anspruch ist, dass die emittierenden Zentren geringere Wechselwirkungen aufweisen. Damit werden Emissionslöschprozesse aufgrund von Triplett-Triplett-Annihilationen reduziert. Das hat zur Folgte, dass derartige Materialien (Komplexe) in höheren Konzentrationen in den Emitterschichten von OLEDs verwendet werden können. Das zeigt sich - wie unten dargestellt - an einer hohen Emissionsquantenausbeute selbst im Feststoff (100 % Emittermaterial). Zum Beispiel beträgt die bei 300 K gemessene Emissionsquantenausbeute für 100 % [Au(dipnc)(PPh₃)] ebenso wie in einem PMMA-Film mit einer Komplexkonzentration von ungefähr einem Gewichtsprozent (70 ± 15) %. Damit ergibt sich, dass OLED-Vorrichtungen mit vergleichsweise hoher Effizienz bei höheren Stromdichten und somit höheren Helligkeiten betrieben werden können. Dieses Verhalten wird von dem Fachmann als geringes Roll-Off-Verhalten bezeichnet.

Bevorzugte Ausführungsformen von Komplexen der allgemeinen Formel (I) werden im Folgenden detailliert beschreiben.

### Gruppe A: geladene Komplexe der Formel (II)

Die Liganden L-L und L' können bevorzugt Phosphane, Arsane, Isonitrile, Thioether oder Selenoether sein. Zur Erreichung einer einfachen Synthese werden vorteilhafter Weise identische Liganden verwendet. Die bevorzugten Anionen sind schwach koordinierend, wie z. B. BF4⁻, PF₆⁻, SbF₆⁻, NO₃⁻ und ClO₄⁻.

### Untergruppe A1:

In dieser Untergruppe gemäß obiger Definition ergeben sich entweder bimetallische oder polymere Strukturen. Bei den bimetallischen Verbindungen sind solche bevorzugt, die keine Metall-Metall-Wechselwirkungen ausbilden, d. h. keine direkten Au-Au-Wechselwirkungen besitzen. Daher ist es notwendig, dass die Verbrückung des zweizähnigen Liganden L-L entweder rigide ist, wie es z. B. durch die Verwendung von cyclischen Brücken erreicht werden kann oder lang ist.

Besonders bevorzugte Liganden sind Bisphosphane und Bisarsane wie: R₂P(CH₂)ₙPR₂, R₂As(CH₂)ₙAsR₂ (n = 1 - 20, bevorzugt n = 3, 4, 5).

Bevorzugt sind auch Komplexe, bei denen L-L = L' ist. Dadurch ergibt sich eine Summenformel von [(L-L)_{1,5}Au]¹⁺ [Anion]. In der folgenden Darstellung werden nur die Kationen gezeigt, nicht jedoch das Anion.

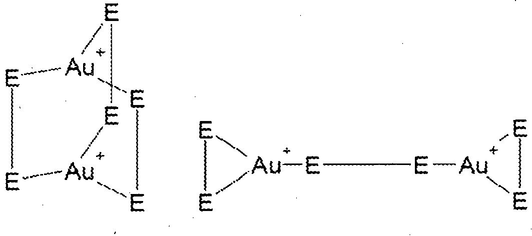

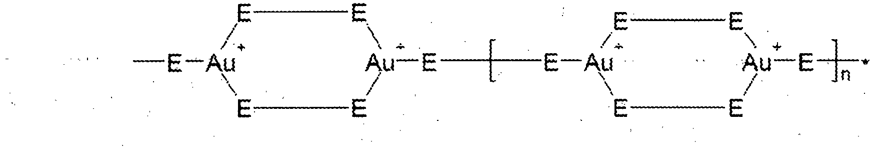

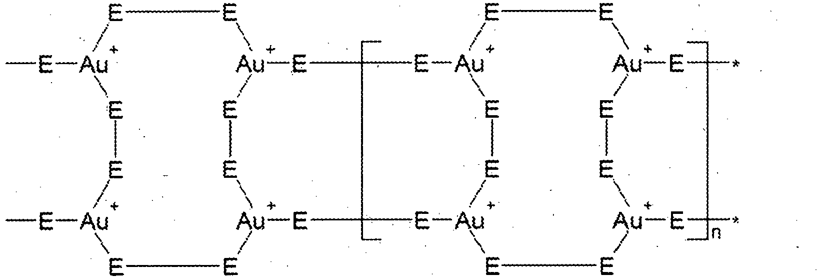

E-E repräsentiert ein Bisphosphan oder -arsan mit E = PR₂, PRR', AsR₂, AsRR'. Einige Beispiele für Bisphosphane werden weiter unten präsentiert. R und R' sind unten definiert.

### Untergruppe A2:

Bei der Koordination eines bidentaten und eines monodentaten Liganden ergeben sich entweder ein-, zwei- oder mehrkernige Komplexe. Besonders bevorzugt sind Phosphan- und Arsanliganden. Im Folgenden werden nur die Kationen (ohne Anion) gezeigt.

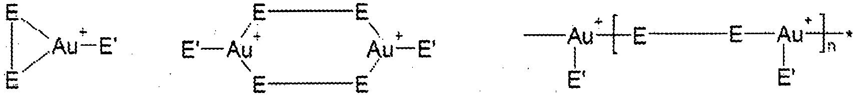

E-E repräsentiert ein Bisphosphan oder -arsan mit E = PR₂, PRR', AsR₂, AsRR', E' repräsentiert ein Monophosphan oder -arsan mit E' = PR₃, PR₂R', PRR'R", AsR₃, AsR₂R', AsRR'R". R, R' und R" sind unten definiert.

### Untergruppe A3:

Bei der Koordination eines tridentaten Liganden ergeben sich entweder ein-, zwei- oder vielkernige Komplexe. Besonders bevorzugt sind wieder Phosphan- und Arsanliganden: Im Folgenden werden nur die Kationen gezeigt.

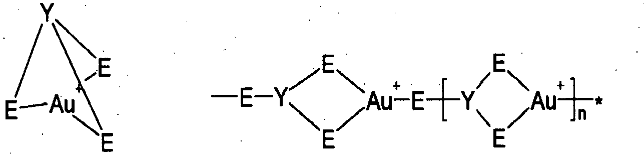

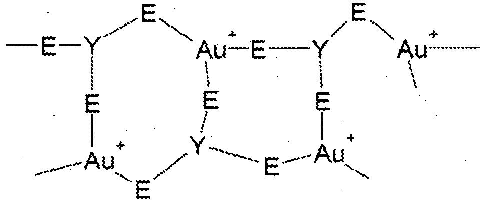

Y repräsentiert einen Verzeigungspunkt; E einen Phosphan- oder Arsanrest mit E = PR₂, PRR', AsR₂, AsRR'. R und R' sind unten definiert. Beispiele für tridentate Phosphan- und Arsanliganden sind:
Y = HC, N
HC[(CH₂)ₙPPh₂]₃, N[(CH₂)ₙPPh₂]₃, HC[(CH₂)ₙAsPh₂]₃, N[(CH₂)ₙAsPh₂]₃, n = 0, 1 - 20, bevorzugt n = 1, 2, 3, 4, 5; Ph = Phenyl.

### Gruppe B: neutrale Komplexe der Formel (III)

### Untergruppe B1:

L-L bildet einen bidentaten, neutralen Liganden. Beispiele hierfür sind zweizähnige Phosphane, Arsane, Isonitrile, Thioether oder Selenoether. Besonders bevorzugt sind Bisphosphane (s.u.) und Bisarsane. L' ist ein einfach geladener, monodentater Ligand wie z. B. Cl⁻, Br⁻, I⁻, SCN⁻, RS⁻, RSe⁻, RC≡C⁻, RC=CH⁻, RCH₂⁻, RR'CH⁻, R₃C⁻, RC=CH⁻, CN⁻, Aryl⁻.
Aryl⁻ ist bevorzugt C₆H₅⁻, C₆F₅⁻; R₃C⁻ ist bevorzugt F₃C⁻.

Folgende Koordinationsmuster können sich ergeben, wenn z. B. ein Bisphosphan oder - arsan (mit E = PR₂, PRR', AsR₂, AsRR') verwendet wird und L' einen der oben dargestellten anionischen Liganden repräsentiert.

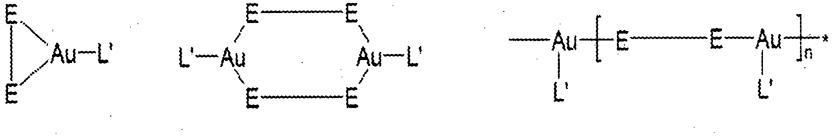

Folgende Beispiele sollen diese Verbindungsklasse weiter verdeutlichen:

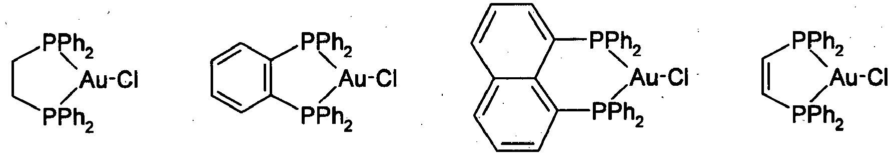

### Untergruppe B2:

L-L ist ein bidentater, einfach negativ geladener Ligand, z. B. ein zweizähniges Phosphan, Arsan, Isonitril, Thioether oder Selenoether. Besonders bevorzugt sind Bisphosphane und Bisarsane (s. u.). L' ist ein neutraler, monodentater Ligand wie z. B. Phosphan PR₃, PR₂R', PRR'R", Arsan AsR₃, AsR₂R', AsRR'R", Isonitril RNC, Thioether R-S-R', Selenoether R-Se-R'. Besonders bevorzugt sind jeweils Phosphane und Arsane.

Bevorzugte, einfach negativ geladene Bisphosphane sind z. B.:

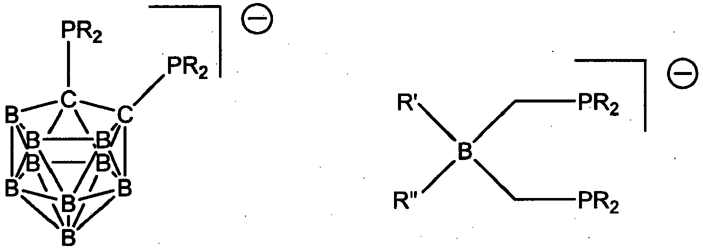

Die Bindung zum Zentralion erfolgt über P-Atome.

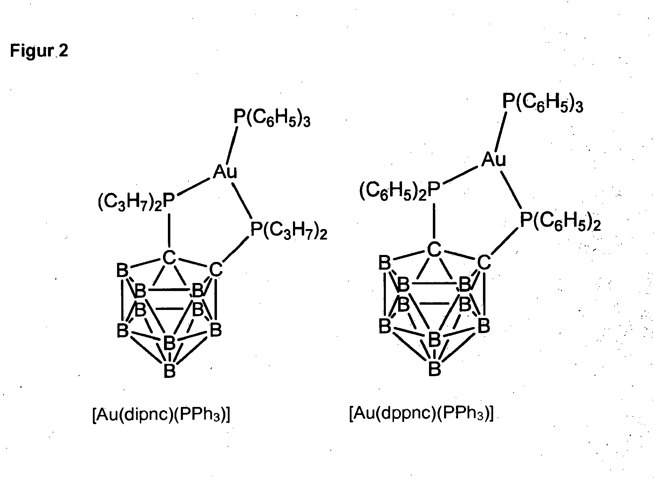

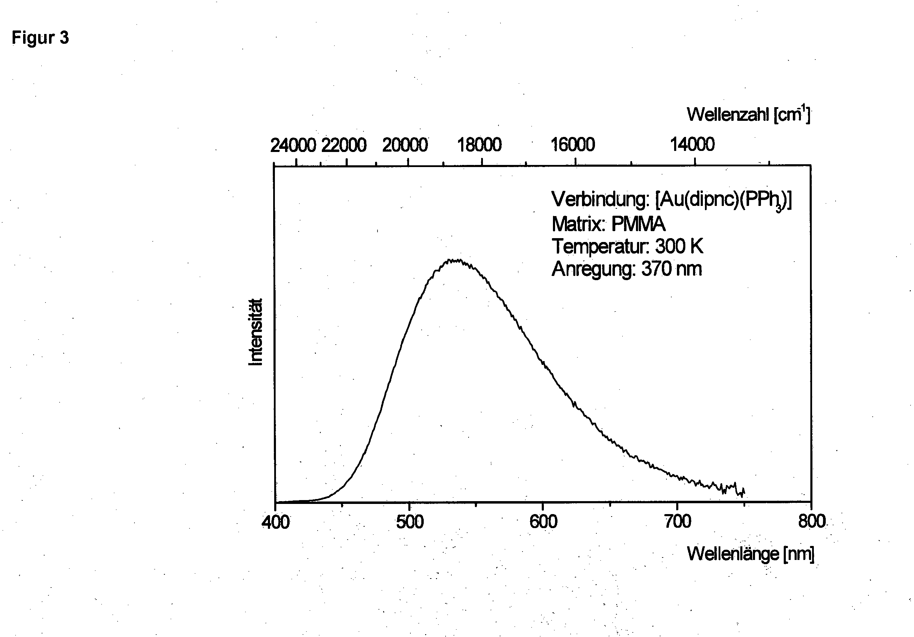

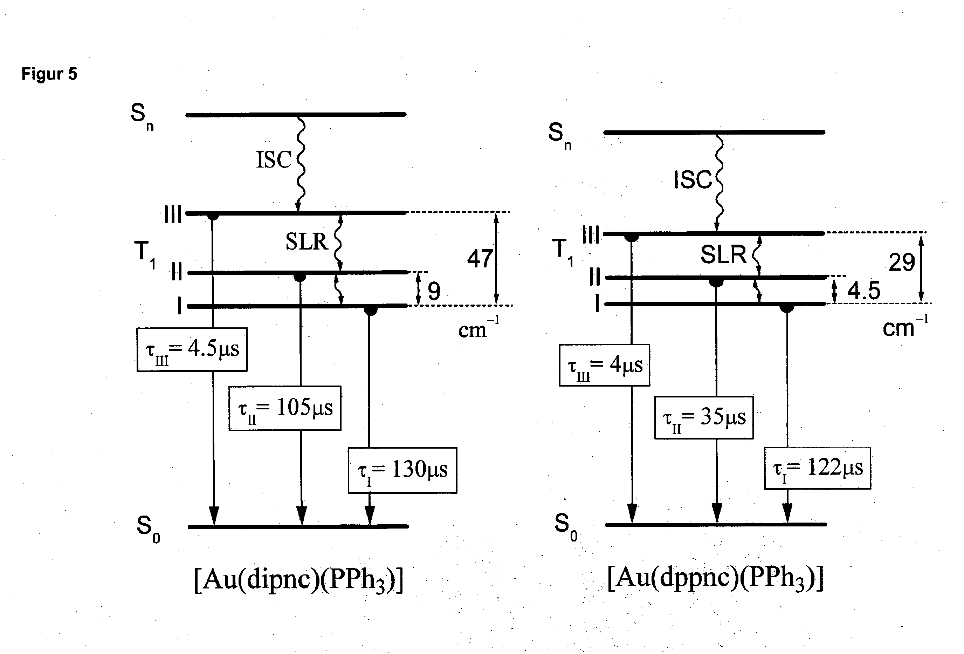

Beispiele von Gold-Komplexen dieser Untergruppe sind die Verbindungen [Au(dipnc)(PPh₃)] und [Au(dppnc)(PPh₃)], deren Strukturen in der Figur 2 gezeigt sind und deren physikalische Eigenschaften im Abschnitt "Beispiele" sowie den Figuren 3 bis 5 angegeben sind.

### Untergruppe B3:

L' ist mit L-L verbunden und bildet einen tridentaten, einfach negativ geladenen Liganden L-L-L', z. B. ein dreizähniges Phosphan, Arsan, Isonitril, Thioether, Selenoether. Besonders bevorzugt sind Trisphosphane und Trisarsane (s. u.).

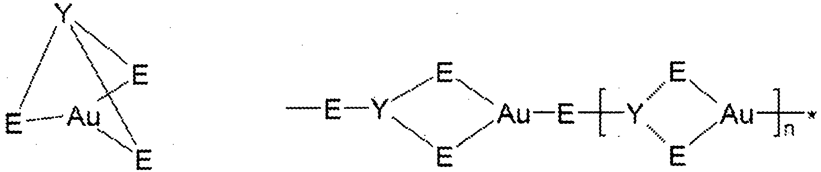

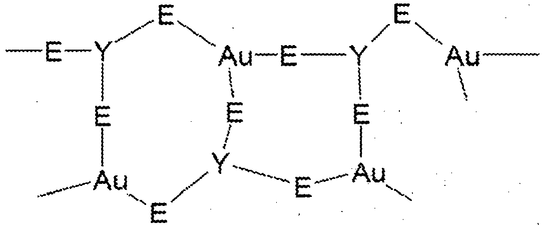

Y repräsentiert einen Verzeigungspunkt, der bevorzugt negativ geladen ist; E einen Phosphan- oder Arsanrest mit E = PR₂, PRR', AsR₂, AsRR'. Beispiele für tridentate Phosphan- oder Arsanliganden sind: Y = R'B
{R'B[(CH₂)ₙPPh₂]₃}⁻, {R'B[(CH₂)ₙAsPh₂]₃}⁻ n = 1 - 20, bevorzugt n = 1, 2, 3, 4, 5

### Definitionen:

### Substitutenten R; R' und R":

Die in den oben dargestellten Substanzen enthaltenen Substituenten R, R' und R" können jeweils unabhängig voneinander sein: Wasserstoff, Halogen oder Substituenten, die über Sauerstoff bzw. Stickstoff gebunden sind (z. B. -OR"', -NR"'₂, R'" definiert wie R, R' und R"), sowie Alkyl-, Aryl-, Heteroaryl-, Alkenyl-, Alkinyl-, Trialkylsilyl- und Triarylsilyl-Gruppen bzw. substituierte Alkyl-, Aryl-, Heteroaryl- und Alkenyl-Gruppen mit Substituenten wie Halogene und niedrige Alkylgruppen. Die Gruppe R, R' und R" können auch Funktionen enthalten, die zur Polymerisation (z. B. Vinylgruppen, Epoxide, cyclische Ether), Polyaddition (z. B. Cyanate / Alkohole => Polyurethane), Polykondensation (Carboxylate / Amine bzw. Alkohole => Polyamide bzw. Polyester), "Click-Reaktion" (kombination Alkin / organisches Azid) oder für Kupplungsreaktionen (z. B. Arylhalogenid / Organoboronsäure oder Halogenid / Olefin) befähigt sind. Um die Flüchtigkeit der Verbindung zu erhöhen, kann die Gruppe R, R' und R" auch fluoriert sein. Um die Verbindungen wasserlöslich zu gestalten, können die Gruppen R, R' und R" auch Sulfonat- (-SO₃H), Phosphonat- (-PO₃H₂) und Carboxylat-Funktionen (-CO₂H) enthalten.

Falls nicht anders angegeben, bezeichnet der Ausdruck "Alkyl-", wie hierin verwendet, jeweils unabhängig eine C₁ - C₃₀, bevorzugt eine C₁ - C₂₀, und insbesondere eine C₁ - C₆ Kohlenwasserstoffgruppe. Die Kohlenwasserstoffgruppen können linear oder verzweigt sein, und können gesättigt sein oder eine oder meherere C=C-Doppelbindungen oder C=C-Dreifachbindungen aufweisen.

Der Ausdruck "Aryl-" bezeichnet ein aromatisches System mit 5 bis z. B. 20 C-Atomen, insbesondere mit 6 bis 10 C-Atomen, wobei gegebenenfalls ein oder mehrere C-Atome durch Heteroatome ersetzt sein können (also z. B. mit N, S und/oder O).

Beispiele für bidentate Phosphanliganden sind die folgenden (R kann verschieden oder gleich sein und entspricht der obigen Definition):

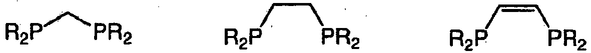

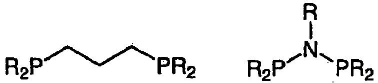

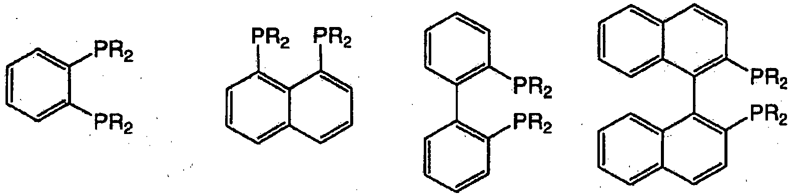

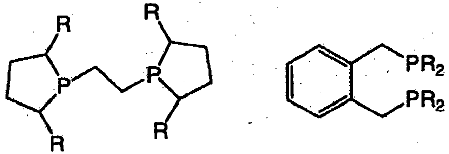

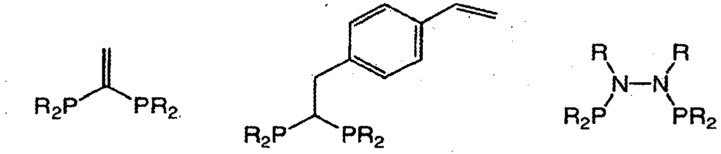

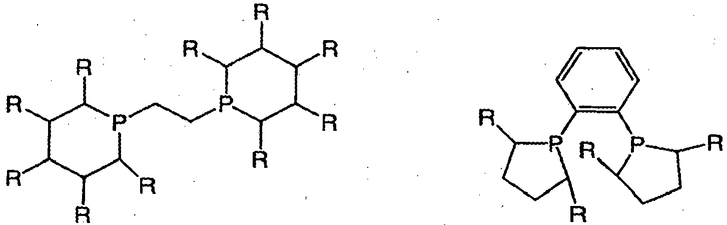

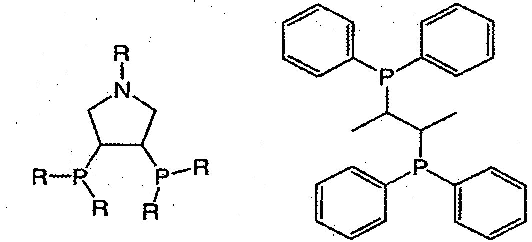

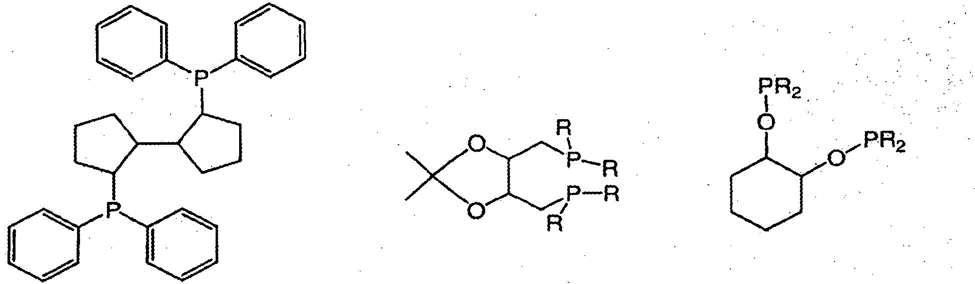

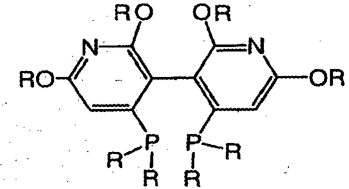

Die Erfindung wird durch die Figuren und die nachfolgenden Beispiele weiter erläutert.
- **Figur 1**: zeigt eine schematische und vereinfachte Darstellung zur Funktionsweise eines OLEDs.
- **Figur 2**: zeigt die Strukturfomeln der als Beispiel beschriebenen Gold-Komplexe gemäß Formel (I). i-Pr = Isopropyl, Ph = Phenylgruppe.
- **Figur 3**: zeigt das Lumineszenzspektrum von [Au(dipnc)(PPh₃)].
- **Figur 4**: zeigt das Lumineszenzspektrum von [Au(dppnc)(PPh₃)].
- **Figur 5**: zeigt Energieniveau-Diagramme mit Emissionsabklingdauern für die drei niedrigsten Triplett-Unterniveaus von [Au(dipnc)(PPh₃)] und [Au(dppnc)(PPh₃)] in 2-Methyltetrahydrofuran. ISC und SLR stehen für "inter-system crossing" und "spin-lattice relaxation" Prozesse, die für die Population der T₁ Unterniveaus und das thermische Gleichgewicht zwischen diesen verantwortlich sind. Diese Begriffe sind dem Fachmann bekannt.

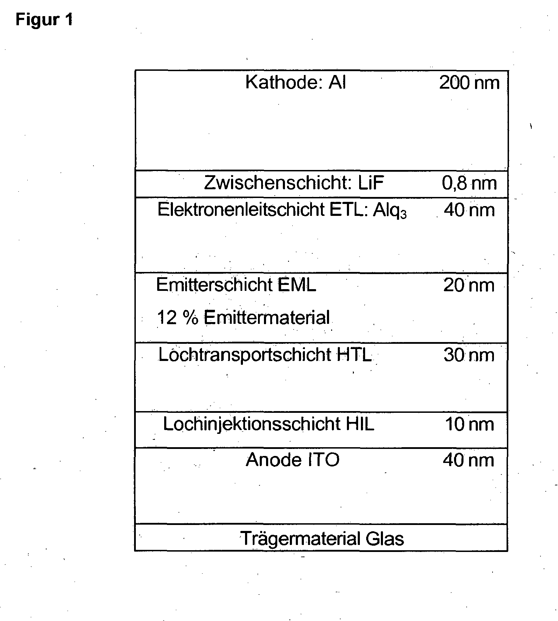

**Figur 1** zeigt die Funktionsweise einer Ausführungsform eines OLEDs schematisch. Die Vorrichtung umfasst mindestens eine Anode, eine Kathode und eine Emitterschicht.

Vorteilhafter Weise wird eine oder beide der als Kathode oder Anode verwendeten Elektroden transparent ausgestaltet, so dass das Licht durch diese Elektrode emittiert werden kann. Bevorzugt wird als transparentes Elektrodenmaterial Indium-Zinn-Oxid (ITO) verwendet. Besonders bevorzugt wird eine transparente Anode eingesetzt. Die andere Elektrode kann ebenfalls aus einem transparenten Material ausgebildet sein, kann aber auch aus einem anderen Material mit geeigneter Elektronenaustrittsarbeit gebildet sein, falls Licht nur durch eine der beiden Elektroden emittiert werden soll. Vorzugsweise besteht die zweite Elektrode, insbesondere die Kathode, aus einem Metall mit hoher elektrischer Leitfähigkeit, beispielsweise aus Aluminium, oder Silber, oder einer Mg/Ag-oder einer Ca/Ag-Legierung.

Zwischen den beiden Elektroden ist eine Emitterschicht angeordnet. Diese kann in direktem Kontakt mit der Anode und der Kathode sein, oder in indirektem Kontakt, wobei indirekter Kontakt bedeutet, dass zwischen der Kathode oder Anode und der Emitterschicht weitere Schichten enthalten sind, so dass die Emitterschicht und die Anode oder/und Kathode sich nicht berühren, sondern über weitere Zwischenschichten elektrisch miteinander in Kontakt stehen. Beim Anlegen einer Spannung, beispielsweise einer Spannung von 2 V bis 20 V, insbesondere von 5 V bis 10 V, treten aus der Kathode, beispielsweise einer leitenden Metallschicht, besonders bevorzugt aus einer Aluminium-Kathode negativ geladene Elektronen aus und wandern in Richtung der positiven Anode. Von dieser Anode ihrerseits aus wandern positive Ladungsträger, sogenannte Löcher, in Richtung der Kathode. In der zwischen der Kathode und Anode angeordneten Emitterschicht befinden sich erfindungsgemäß Gold-Komplexe der Formel (I), insbesondere der Formeln II oder III als Emitter. An den Emitter-Komplexen oder in deren Nähe rekombinieren die wandernden Ladungsträger, also ein negativ-geladenes Elektron und ein positiv geladenes Loch, und führen dabei zu neutralen, aber energetisch angeregten Zuständen der Emitter-Substanzen. Die angeregten Zustände der Emitter geben dann die Energie als Lichtemission ab.

Die erfindungsgemäßen Licht emittierenden Vorrichtungen können, soweit die Emittermaterialien sublimierbar sind, über Vakuumdeposition hergestellt werden. Alternativ ist auch ein Aufbau über nass-chemische Auftragung möglich, beispielsweise über Spin-Coating-Verfahren, über Inkjet-Printen oder über Siebdruckverfahren. Der Aufbau von OLED-Vorrichtungen wird beispielsweise in der US 2005/0260449 A1 sowie in der WO 2005/098988 A1 beschrieben.

Die erfindungsgemäßen Licht emittierenden Vorrichtungen können mittels der Vakuum-Sublimations-Technik gefertigt werden und mehrere weitere Schichten enthalten, insbesondere eine Elektronen-Injektionsschicht und eine Elektronen-Leitungsschicht (z. B. Alq₃ = Aluminium-8-hydroxychinolin oder β-Alq = Aluminium-bis(2-methyl-8-hydroxychinolato)-4-phenylphenolat) und/oder eine Loch-Injektions- (z. B. CuPc = KupferPhthalocyanin) und Loch-Leitungsschicht oder Loch-Leitungsschicht (z.B. α-NPD = 4,4'-Bis[N-(1-naphtyl)-N-phenylamino)biphenyl]). Es ist aber auch möglich, dass die Emitterschicht Funktionen der Loch- bzw. Elektronen-Leitungsschicht übernimmt.

Die Emitterschicht besteht vorzugsweise aus einem organischen Matrixmaterial mit ausreichend großem Singulett S₀ - Triplett T₁-Energieabstand (Matrix-Material), z. B. PVK (Polyvinylcarbazol), CBP (4,4'-Bis(9-carbazolyl)biphenyl) oder anderen Matrixmaterialien. In dieses Matrixmaterial kann der Emitter-Komplex eindotiert werden, z. B. mit 1 bis 100 Gewichtsprozent (Gew-%), insbesondere mit 3 bis 20 Gewichtsprozent. Die Anwendung mit 100 Gewichtsprozent bedeutet, dass der entsprechende Komplex in reiner Form (zu 100 %) aufgebracht wird. Zum Beispiel beträgt die bei 300 K gemessene Emissionsquantenausbeute für 100 % [Au(dipnc)(PPh₃)] ebenso wie in einem PMMA-Film mit einer Komplexkonzentration von ungefähr einem Gewichtsprozent (70 ± 15) %.

### Beispiele

### Beispiel-Komplexe:

Beispiel 1: [Au{C₂B₉H₁₀(P(C₃H₇)₂)₂}{P(C₆H₅)₃}] = [Au(dipnc)(PPh₃)]
Beispiel 2: [Au{C₂B₉H₁₀(P(C₆H₅)₂)₂}{P(C₆H₅)₃}] = [Au(dppnc)(PPh₃)]

Die Strukturen der genannten Verbindungen sind in Figur 2 dargestellt.

### Syntheseweg:

[Au(tetrahydrothiophen){P(C₆H₅)₃}]ClO₄ + C₂B₁₀H₁₀(PR₂)₂ [Au{C₂B₁₀H₁₀(PR₂)₂}{P(C₆H₅)₃}]ClO₄

[Au{C₂B₁₀H₁₀(PR₂)₂}{P(C₆H₅)₃}]ClO₄ [Au{C₂B₉H₁₀(PR₂)₂}{P(C₆H₅)₃}]

R = Isopropyl (Beispiel 1) oder Phenyl (Beispiel 2)

Die Ausgangsverbindungen [Au(tetrahydrothiophen)(P(C₆H₅)₃]ClO₄ und C₂B₁₀H₁₀(PR₂)₂ können nach Literaturvorschriften, z. B. nach [Uson, R.; Laguna, A.; Laguna, M.; Jimenez, J.; Gomez, M. P.; Sainz, A.; Jones, P. G. J. Chem. Soc., Dalton Trans. 1990, 3457.] und [Alexander, R. P.; Schoeder, H. Inorg Chem. 1963, 26, 1107.] hergestellt werden.

### Lumineszenzspektren:

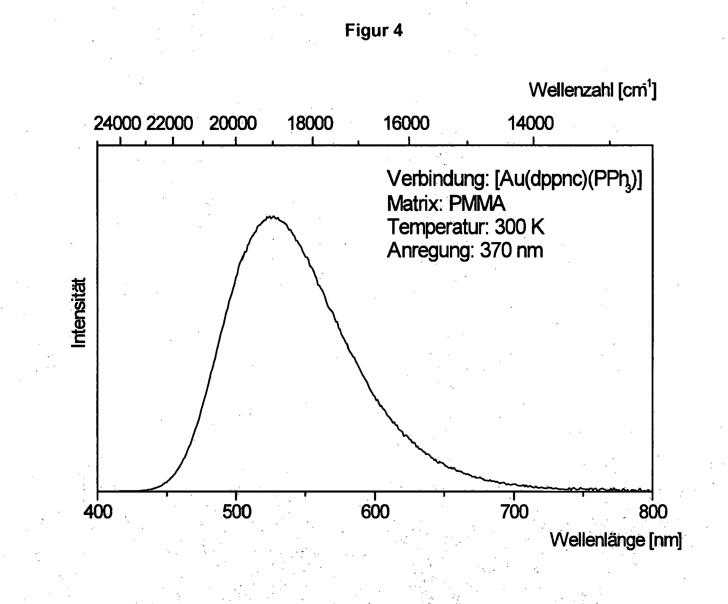

Das Lumineszenzspektrum von [Au(dipnc)(PPh₃)] ist in Figur 3 dargestellt.
Das Lumineszenzspektrum von [Au(dppnc)(PPh₃)] ist in Figur 4 dargestellt.

**Lumineszenzeigenschaften:**

| Gold-Komplex: | [Au(dipnc)(PPh₃)] | [Au(dppnc)(PPh₃)] |
|---|---|---|
| λₘₐₓ/τ bei 300 K | 525 nm / 12 µs | 534 nm / 8 µs |
| λₘₐₓ/τ bei 77 K | 508 nm / 20 µs | 497 nm / 15 µs |
| φ_{PL} (300 K) | 75 % | 50% |

| | | |
|---|---|---|
| λₘₐₓ = Emissionsmaximum und τ = Emissionsabklingzeit gemessen in einer verdünnten 2-Methyltetrahydrofuran-Lösung φ_{PL} = Photolumineszenz-Quantenausbeute gemessen in PMMA (Polymethylmethacrylat) bei Raumtemperatur. | | |

## Patentansprüche

1. Verwendung eines Gold-Komplexes der Formel I mit planar-trigonaler Koordinationsgeometrie als Triplett-Emitter in in einer opto-elektronischen Vorrichtung in Form einer organischen Licht emittierenden Diode oder einer Licht emittierenden elektrochemischen Zelle
**[(L-L)(L')Au]^{0/1+} [Anion]^{0/1}** Formel (I)
mit
**(L-L) :** einem ersten Liganden, der zweizähnig ist,
**(L') :** einem zweiten Liganden, der ein- oder zweizähnig ist,
**Au** : einem Gold(I)-Zentralion und
**Anion :** einem Gegenanion, das vorhanden ist, wenn [(L-L)(L')Au]¹⁺ ist.

2. Verwendung nach Anspruch 1, wobei ein elektrisch geladener Gold-Komplex der Formel (II) mit planar-trigonaler Koordinationsgeometrie als Triplett-Emitter in in einer opto-elektronischen Vorrichtung verwendet wird
**[(L-L)(L')Au]¹⁺ [Anion]** Formel (II).

3. Verwendung eines Gold-Komplexes nach Anspruch 1, wobei ein elektrisch neutraler Gold-Komplex der Formel (III) mit planar-trigonaler Koordinationsgeometrie als Triplett-Emitter in in einer opto-elektronischen Vorrichtung verwendet wird
**[(L-L)(L')Au]** Formel (III).

4. Verwendung nach Anspruch 1 bis 3, wobei der Gold-Komplex eine bei T = 300 K gemessene Emissionsabklingzeit von 2 µs bis 20 µs, bevorzugt 2 µs bis 15 µs aufweist.

5. Verwendung nach Anspruch 1 bis 4, wobei der Gold-Komplex eine bei T = 300 K gemessene Emissionsquantenausbeute von mindestens 35 %, bevorzugt von mindestens 50 %, stärker bevorzugt von mindestens 75 % oder mindestens 95 % aufweist.

6. Opto-elektronische Vorrichtung in Form einer organischen Licht emittierenden Diode oder einer Licht emittierenden elektrochemischen Zelle, aufweisend einen Gold-Komplex der Formel (I), (II) oder (III) mit planar-trigonaler Koordinationsgeometrie als Triplett-Emitter.

7. Opto-elektronische Vorrichtung nach Anspruch 6,
**dadurch gekennzeichnet,**
**dass** der Anteil von Komplexen der Formel (I), (II) oder (III) in einer Emitterschicht 2 bis 100 Gew.-%, bevorzugt 3 bis 20 Gew.-% oder 100 Gew.-%, bezogen auf das Gesamtgewicht der Emitterschicht, beträgt.

8. Verfahren zur Herstellung einer opto-elektronischen Vorrichtung in Form einer organischen Licht emittierenden Diode oder einer Licht emittierenden elektrochemischen Zelle, wobei ein Gold-Komplex gemäß Formel (I), (II), oder (III) mit planar-trigonaler Koordinationsgeometrie als Triplett-Emitter verwendet wird.

## Claims

1. Use of a gold complex of formula I with trigonal planar coordination geometry as a triplet emitter in an optoelectronic device in the form of an organic light emitting diode or a light emitting electrochemical cell
[(L-L)(L')Au]^{0/1+} [Anion]^{0/1} Formula (I)
with
(L-L) : a first ligand that is bidentate,
(L'): a second ligand that is mono- or bidentate,
Au : a gold(I) central ion and
Anion : a counter ion that is present in case of [(L-L)(L')Au]¹⁺.

2. Use according to claim 1, wherein an electrically charged gold complex of formula II with trigonal planar coordination geometry is used as triplet emitter in an opto-electronic device
[(L-L)(L')Au]¹⁺ [Anion] Formula (II).

3. Use of a gold complex according to claim 1, wherein an electricly neutral gold complex of formula (III) with trigonal planar coordination geometry is used as triplet emitter in an opto-electronic device
[(L-L)(L')Au] Formula (III).

4. Use according to claims 1 to 3, wherein the gold complex has an emission decay time measured at T= 300 K of 2 µs to 20 µs, preferably of 2 µs to 15 µs.

5. Use according to claims 1 to 4, wherein the gold complex has an emission quantum yield of at least 35 %, preferably of at least 50 %, more preferred of at least 75 % or at least 95 %.

6. Opto-electronic device in the form of an organic light emitting diode or of a light emitting electrochemical cell, comprising a gold complex of formula (I), (II) or (III) with trigonal planar coordination geometry as triplet emitter.

7. Opto-electronic device according to claim 6,
**characterized in that**
the portion of complexes of formula (I), (II) or (III) in an emitter layer is 2 to 100 weight-%, preferably 3 to 20 weight-% or 100 weight-%, relative to the total weight of the emitting layer.

8. Method for manufacturing an opto-electronic device in the form of an organic light emitting diode or of a light emitting electrochemical cell, wherein a gold complex of to formula (I), (II) or (III) with trigonal planar coordination geometry is used as triplet emitter.

## Revendications

1. Utilisation d'un complexe d'or de formule I de géométrie de coordination plane-trigonale en tant qu'émetteur de triplets dans un dispositif optoélectronique sous la forme d'une diode électroluminescente organique ou d'une cellule électrochimique électroluminescente
[(L-L)(L')Au]^{0/1+} [Anion]_{0/1} Formule (I)
avec
(L-L) : un premier ligand, qui est bidentate,
(L') : un second ligand, qui est mono- ou bidentate,
Au : un ion central or (I) et
Anion : un contre-anion, qui est présent lorsque [(L-L)(L')Au]¹⁺ l'est.

2. Utilisation selon la revendication 1, dans laquelle un complexe d'or chargé électriquement de formule (II) de géométrie de coordination plane-trigonale est utilisé en tant qu'émetteur de triplets dans un dispositif optoélectronique
[(L-L)(L')Au]¹⁺ [Anion] Formule (II)

3. Utilisation d'un complexe d'or selon la revendication 1, dans laquelle un complexe d'or électriquement neutre de formule (III) de géométrie de coordination plane-trigonale est utilisé en tant qu'émetteur de triplets dans un dispositif optoélectronique
[(L-L)(L')Au] Formule (III).

4. Utilisation selon les revendications 1 à 3, dans laquelle le complexe d'or présente un temps d'extinction d'émission mesuré à T = 300 K de 2 µs à 20 µs, de préférence de 2 µs à 15 µs.

5. Utilisation selon les revendications 1 à 4, dans laquelle le complexe d'or présente un rendement quantique d'émission mesuré à T = 300 K d'au moins 35 %, de préférence d'au moins 50 %, de manière davantage préférée d'au moins 75 % ou d'au moins 95 %.

6. Dispositif optoélectronique sous la forme d'une diode électroluminescente organique ou d'une cellule électrochimique électroluminescente, comprenant un complexe d'or de formule (I), (II) ou (III) de géométrie de coordination plane-trigonale en tant qu'émetteur de triplets.

7. Dispositif optoélectronique selon la revendication 6, **caractérisé en ce que** la proportion de complexes de formule (I), (II) ou (III) dans une couche d'émetteur est de 2 à 100 % en poids, de préférence de 3 à 20 % en poids ou de 100 % en poids, par rapport au poids total de la couche d'émetteur.

8. Procédé de fabrication d'un dispositif optoélectronique sous la forme d'une diode électroluminescente organique ou d'une cellule électrochimique électroluminescente, dans lequel un complexe d'or de formule (I), (II) ou (III) de géométrie de coordination plane-trigonale est utilisé en tant qu'émetteur de triplets.
